# EUROPÄISCHE PATENTANMELDUNG

(11) **EP 0 974 928 A2**
(43) Veröffentlichungstag der Anmeldung: **26.01.2000**
(21) Anmeldenummer: 99111833.2
(22) Anmeldetag: 19.06.1999
(51) Int. Cl.: G06K 19/077

(54) **Chipkarte**

(30) Priorität: 23.07.1998 DE 19833103
(71) Anmelder: Orga Kartensysteme GmbH, 33104 Paderborn (DE)
(72) Erfinder: Isberner, Roland, 24147 Kiel (DE)

(57) **Zusammenfassung**

Es wird eine Chipkarte beschrieben, bei der ein den Chip (IC-Baustein) enthaltenes Trägerelement als separates Bauteil mittels eines photolumineszierenden Klebers in eine Aussparung des Kartenkörpers eingesetzt ist.

## Beschreibung

Die Erfindung bezieht sich auf Chipkarten, ein Verfahren zur Herstellung eines Zwischenerzeugnisses für Chipkarten und auf ein System zur Prüfung der Echtheit von Chipkarten.

Chipkarten werden u.a. als Krankenversichertenkarten, Geldkarten, Kreditkarten, Zugangsberechtigungskarten für das GSM-Funknetz und als Telefonkarte eingesetzt. Eine derartige Chipkarte ist beispielsweise aus der DE 41 26 874 C1 bekannt.

Chipkarten dieser Art weisen ein Trägerelement (ein sogenanntes Chipmodul) auf, das in eine Aussparung des Kartenkörpers eingebettet ist. Das Trägerelement besteht aus zwei Teilen, nämlich einem ersten Teil, das auf einem Kunststoffsubstrat elektrisch leitfähige Kontaktflächen für die Energieversorgung und den Datenaustausch des Chips (integrierter Halbleiterbaustein) aufweist, und einem zweiten Teil in Form eines Vergußgehäuses, das den Chip und die Anschlußleitungen des Chips an die elektrischen Kontaktflächen aufnimmt und vor mechanischen Belastungen schützt.

Ein wichtiger Aspekt in Verbindung mit Chipkarten ist der Schutz vor Mißbrauch, insbesondere der Schutz vor Verwendung von gefälschten Chipkarten, wobei der eigentlich sicherheitsrelevante Datenträger der Chip ist, der sich in dem Trägerelement (Chipmodul) befindet.

Aus diesem Grunde wird in der DE 195 23 242 A1 als Sicherheitsmerkmal für Chipkarten vorgeschlagen, das Kunststoffsubstrat auf dem sich die Kontaktflächen befinden, fluoreszierend auszubilden, wobei das Fluoreszenzlicht durch die isolierenden, lichten Zwischenräume zwischen den metallischen Kontaktflächen hindurch sichtbar ist. Hierbei gibt es jedoch den Nachteil, daß es möglich ist, das Trägerelement einschließlich des fluoreszierenden Kunststoffsubstrats ohne Zerstörung desselben mutwillig aus dem Kartenkörper herauszulösen- z.B. durch den Einsatz von Chemikalien, die die Klebeverbindung zwischen Trägerelement und Kartenkörper lösen. Die Tatsache, daß das Trägerelement mit dem Chip als dem eigentlich sicherheitsrelevanten Datenträger der Karte aus dem Kartenkörper beschädigungsfrei herausgelöst werden kann und dann in einen anderen Kartenkörper eingesetzt werden kann, bedeutet ein hohes Sicherheitsrisiko.

Aufgabe der Erfindung ist es, ein Sicherheitsmerkmal für Chipkarten zu schaffen, so daß der vorstehend beschriebene Nachteil vermieden wird.

Diese Aufgabe wird erfindungsgemäß dadurch gelöst, daß zur Fixierung des Trägerelements in der Aussparung des Kartenkörpers ein photolumineszierender Kleber verwendet wird, wobei der photolumineszierender Kleber bei Bestrahlung mit ultravioletter Strahlung dann Licht einer größeren Wellenlänge, vorzugsweise im sichtbaren Bereich, abstrahlt (emittiert). Dabei umfaßt die Photolumineszenz sowohl die Fluoreszenz als auch die Phosporeszenz.

In einer ersten erfindungsgemäßen Ausgestaltung befindet sich der fluoreszierende Kleber zumindest teilweise auch in einer umlaufenden Rille (Spalt) zwischen Trägerelement und Kartenkörper, die beim Einsetzten des Trägerelements in die Aussparung des Kartenkörpers normalerweise freibleibt. Somit ist ein lichter Zugang zu dem ansonsten verdeckt unter dem Kunststoffsubstrat liegenden Kleber geschaffen. Auf diese Weise kann einerseits die für die Anregung der Photolumineszenz benötigte ultraviolette Strahlung, z.B. von einer sogenannten Schwarzlichtlampe, zum Kleber gelangen, und andererseits das Photolumineszenzlicht vom Kleber zum Auge des Betrachters oder in einen entsprechenden Sensor gelangen.

In einer zweiten erfindungsgemäßen Ausgestaltung wird ein Kunststoffsubstrat für das Trägerelement verwendet, daß für ultraviolette Strahlung und für die Photolumineszenz-Strahlung des Klebers zumindest teilweise transparent ist. Damit kann einerseits die UV-Strahlung durch die lichten Zwischenräume zwischen den metallischen Kontaktflächen hindurch und dann durch das Kunststoffsubstrat zum darunter befindlichen photolumineszierenden Kleber gelangen, und andererseits kann das Photolumineszenlicht vom Kleber durch das Kunststoffsubstrat und die lichten Zwischenräume in der Metallisierung hindurch zum Auge des Betrachters oder in einen entsprechenden Sensor gelangen.

Die Verwendung eines photolumineszierenden Klebers hat gegenüber der Verwendung eines fluoreszierenden Kunststoffsubstrats den entscheidenden Vorteil, daß das Sicherheitsmerkmal, nämlich der photolumineszierende Kleber beim Herauslösen des Trägerelements aus dem Kartenkörper zerstört oder entfernt wird, da der Kleber quasi das Interface zwischen den beiden Zwischenerzeugnissen Trägerelement und Kartenkörper bildet. Beim Wiedereinsetzen des herausgelösten Trägerelements in einen anderen Kartenkörper müßte der Fälscher das Sicherheitsmerkmal wiederherstellen, wodurch der Fälschungsaufwand erhöht wird, insbesondere da photolumineszierende Kleber nicht ohne weiteres für jedermann erhältlich sind.

Ein zusätzliches Maß an Sicherheit kann erreicht werden, wenn photolumineszierende Kleber verwendet werden, deren Photolumineszenzspektrum speziell auf die Parameter eines Sicherheitssystems bestehend aus einer UV-Strahlungsquelle und einem optischen Empfänger abgestimmt ist. Für ein derartiges System wird ebenfalls Schutz beansprucht.

Desweiteren werden nachfolgend Herstellungsverfahren für die erfindungsgemäße Chipkarten und für ein Zwischenerzeugnis beschrieben und für diese Schutz beansprucht.

Anhand der beigefügten Zeichnungen soll die Erfindung nachfolgend näher erläutert werden. Es zeigt:
- Fig.1: eine Draufsicht auf eine Chipkarte mit eingesetztem Trägerelement (Chipmodul),
- Fig.2: eine Draufsicht auf die Rückseite eines Trägerelements,
- Fig.3: einen Schnitt durch ein Trägerelement,
- Fig.3A: einen schematischen Schnitt durch eine Chipkarte im Bereich des Trägerelements,
- Fig.4: eine schematische Skizze zur Herstellung eines Zwischenerzeugnisses bei der Herstellung von Chipkarten,
- Fig.5: eine Draufsicht auf das Zwischenerzeugnis,

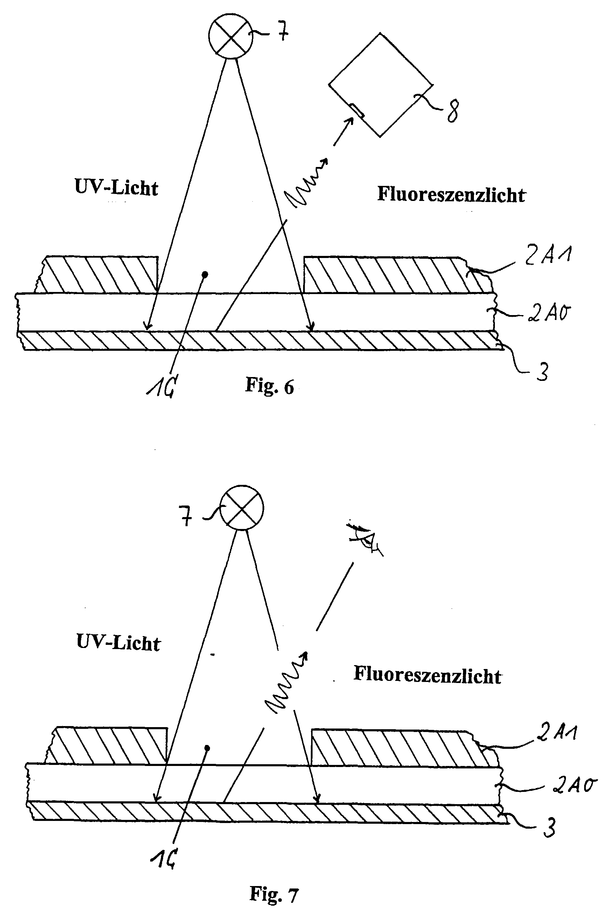

- Fig.6: eine stark vergrößerte Darstellung der Kontaktflächen im Bereich eines isolierenden, lichten Zwischenraums zur Verdeutlichung der geometrisch optischen Verhältnisse unter Einbeziehung einer Schwarzlichtlampe und eines optischen Sensors zum Empfang der Photolumineszenzstrahlung,
- Fig.7: wie Fig.6, jedoch mit dem Auge des Betrachters statt eines Sensors,
- Fig.8A: einen stark vergrößerten Schnitt durch den Kartenkörper im Bereich der Aussparung mit dem noch nicht vollständig eingesetzten Trägerelement,

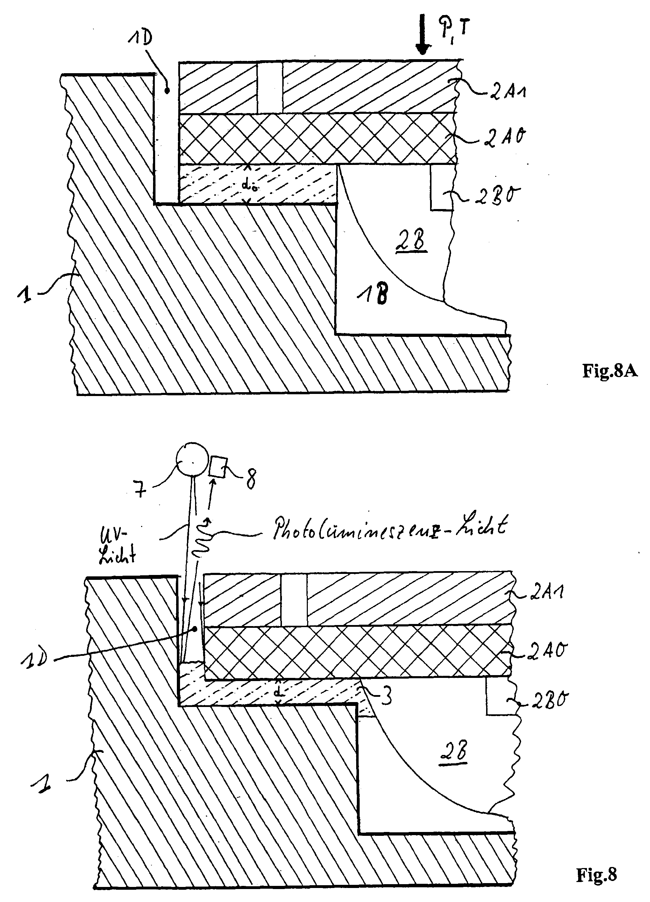

- Fig.8: wie Fig.8A, jedoch bei vollständig eingesetztem Trägerelement, wobei der Kleber teilweise in die um das Trägerelement umlaufende Rille gequollen ist,

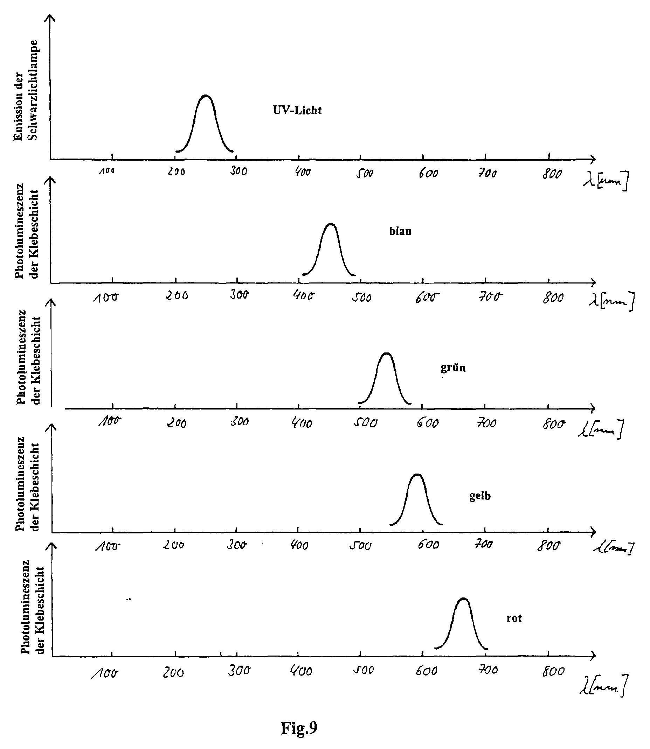

- Fig.9: das Emissionsspektrum der Schwarzlichtlampe sowie Photolumineszenzspektren für jeweils unterschiedlich photolumineszierende Klebeschichten.

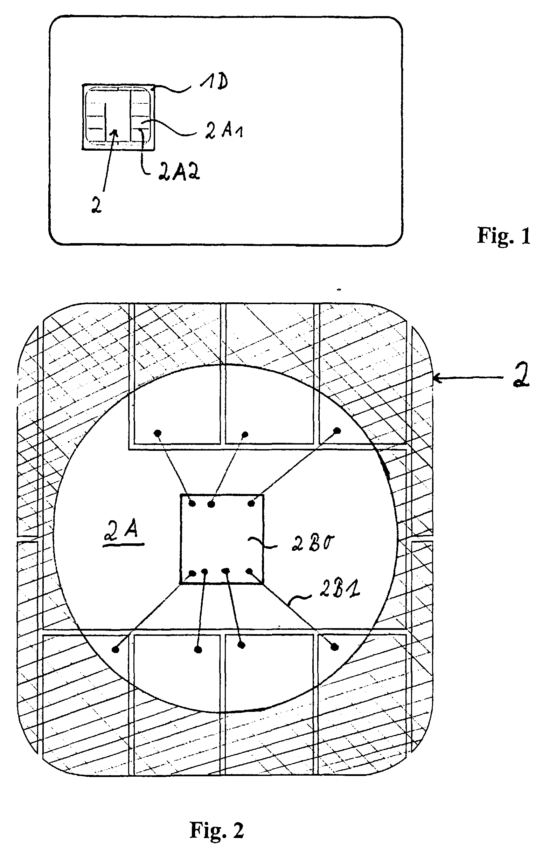

In Fig.1 ist eine Chipkarte in der Draufsicht gezeigt. Das Trägerelement (2) mit seinen Kontaktflächen (2A1) ist unter Freilassung einer umlaufenden Rille (1D) in eine Aussparung des Kartenkörpers (1) implantiert. Aus Gründen der Standardisierung ist in der ISO 7816-2 die Lage und Mindestgröße von Normkontaktflächen vorgegeben; tatsächlich sind die Kontaktflächen (2A1) meist etwas größer als die durch die Norm vorgeschriebene Mindestgröße. Zur Ausbildung der Kontaktflächen sind in der Metallisierung, die die elektrisch leitfähigen Kontaktflächen bildet, isolierende, lichte Zwischenräume (2A2) vorgesehen. Die Breite der Zwischenräume (2A2) beträgt ca. 200 µm. Die Breite der umlaufenden Rille (1D) liegt ungefähr in derselben Größenordnung.

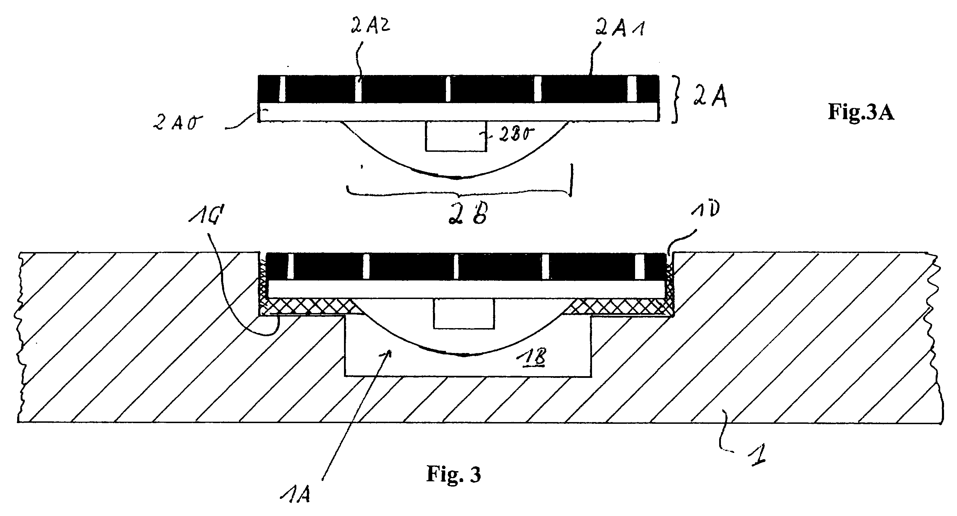

Das Trägerelement (2) - vgl.Fig.3A - ist ein Zwischenerzeugnis bei der Herstellung von Chipkarten, das auch separat gehandelt wird. Je nach Fertigungstiefe eines Chipkartenherstellers fertigt dieser die Trägerelemente (2) selbst und implantiert diese dann mittels eines Klebers (3) in Kartenkörper (1) mit einer entsprechenden Aussparung (1A), oder aber der Chipkartenhersteller bezieht Trägerelemente (2) von Dritten und implantiert diese in Kartenkörper (1).

Ein derartiges als Zwischenerzeugnis hergestelltes Trägerelement (2) kann man aus im wesentlichen zwei Teilen bestehend charakterisieren; nämlich einem ersten Teil (2A), auf dem sich die Kontaktflächen (2A1) befinden, die auf einem Kunststoffsubstrat (2A0) aufgebracht sind, und einem zweiten Teil (2B) in Form eines Vergußgehäuses, das den Chip (2B0) und die Anschlußleitungen des Chips (2B1) an die Kontaktflächen (2A1) aufnimmt und als Schutz vor mechanischen Belastungen und Feuchtigkeit dient. Dabei ragt der erste Teil (2A) über den Rand des zweiten Teils (Vergußgehäuse,2B) seitlich hinaus, wobei der überstehende Bereich zur Fixierung des Trägerelements (2) in der Aussparung (1A) des Kartenkörpers (1) dient. Die Aussparung (1A) im Kartenkörper (1) - vgl. Fig. 3 - besitzt mittig eine Vertiefung (1B), wobei die Aussparung (1A) um die Vertiefung (1B) herum eine Auflageschulter (1C) aufweist. Das Trägerelement (2) ist dabei so in den Kartenkörper (1) eingebettet, daß das erste Teil (2A) mit dem über den Rand des zweiten Teils (2B) hinausragenden Bereich mittels eines photolumineszierenden Klebers (3) auf der Auflageschulter (1C) fixiert ist, während das zweite Teil (2B) innerhalb der Vertiefung (1B) Platz findet.

Damit der photolumineszierende Kleber (3), der sich eigentlich verborgen hinter der Rückseite des Trägerelements (2) befindet, als Sicherheitsmerkmal überhaupt wirksam werden kann, muß die Chipkarte so ausgelegt sein, daß ein lichter Zugang zum photolumineszierenden Kleber (3) vorhanden ist. Nur so kann einerseits das zur Anregung der Photolumineszenz notwendige ultraviollete Licht zum Kleber (3) gelangen, und andererseits das vom Kleber (3) ausgehende Photolumineszenzlicht zum Auge des Betrachters oder zu einem entsprechenden Meßgerät (opt. Sensor, 8) gelangen.

Dies ist in einer ersten Ausgestaltung dadurch gelöst, daß der photolumineszierende Kleber (3) zumindest auch teilweise in die um das Trägerelement (2) umlaufende Rille (1D) hineinragt.

Eine derart ausgestaltete Chipkarte kann durch folgende Verfahrensschritte hergestellt werden -vgl. Fig,8A und Fig.8 -:
In einem 1. Schritt wird ein Trägerelement (2) bereit gestellt, auf dessen Rückseite (den Kontaktflächen gegenüberliegend) eine photolumineszierende Heißklebeschicht (Schmelzkleber, 3) aufgebracht ist. Eine derartige Klebeschicht (3) wird unter dem Einfluß von Druck und Wärme aktiviert, wobei die Klebeschicht (3) unter Dickenverminderung seitlich 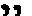 überquillt", d.h. die Fläche der Klebeschicht (3) wird zu Lasten der Dicke verringert. Dann wird in einem 2. Schritt ein Kartenkörper (1) mit einer entsprechenden Aussparung (1A) bereitgestellt. Nun wird in einem 3. Schritt schließlich das vorstehend beschriebene Trägerelement (2) mittels eines beheizten Stempels (nicht dargestellt) unter dem Einfluß von Druck (P) und Wärme (T) in die Aussparung (1A) des Kartenkörpers (1) eingesetzt. Beträgt die Dicke der Klebeschicht (3) zu Beginn d₀ so beträgt sie nach der Implantation nur noch d (d < d₀). Infolge davon befindet sich der photolumineszierende Heißkleber (3) nun nach der Implantation zum Teil auch in der um das Trägerelement (2) umlaufenden Rille (1D), wodurch ein lichter Zugang zur Klebeschicht (3) ermöglicht wird. Damit die photolumineszierende Klebeschicht (3) nach der Implantation zumindest teilweise in die Rille (1D) hineinragt, sind die Dauer der Druck- und Wärmebeaufschlagung, der Druck und die Temperatur selbst sowie die Fläche und Dicke der aufgebrachten Heißklebeschicht (3) entsprechend aufeinander abgestimmt. Die Heißklebeschicht (3) wird dazu vor der Implantation vorzugsweise so auf das Kunststoffsubstrat aufgebracht, daß sie mit dem Rand des Kunststoffsubstrats (2A0) bündig abschließt -vgl. Fig.2.

In Fig.2 ist eine Draufsicht auf die Rückseite des Trägerelements (2) gezeigt. Zu erkennen ist die Umrandung des transparent eingezeichneten Vergußgehäuses (2B), das den Chip (2B0) und die Anschlußleitungen des Chips (2B1) an die Kontaktflächen (2A1) aufnimmt. Mit Ausnahme des Vergußgehäuses (2B) befindet sich auf der gesamten Rückseite des Trägerelements (2) eine photolumineszierende Heißklebeschicht (3), die auf dem in dieser Ansicht nicht dargestellten Kunststoffsubstrat angeordnet ist.

In einem alternativen Herstellungsverfahren (nicht dargestellt) wird vor der Implantation des Trägerelements in die Aussparung des Kartenkörpers ein photolumineszierender Kleber, z.B auf der Basis von Cyanacrylat, in flüssiger oder pastöser Form eingebracht. Dabei ist die Menge des eingebrachten Klebers so dimensioniert, daß beim Einsetzen des Trägerelements dieser zumindest teilweise in die um das Trägerelement umlaufende Rille quillt.

In einer zweiten erfindungsgemäßen Ausgestaltung der Chipkarte wird ein Kunststoffsubstrat (2A0) für das Trägerelement (2) verwendet, das für ultraviolette Strahlung und für die Photolumineszenzstrahlung des photolumineszierenden Klebers (3) zumindest teilweise transparent ist. Damit kann einerseits ultraviolette Strahlung durch die lichten Zwischenräume zwischen den Kontaktflächen (2A1) bis zum photolumineszierenden Kleber (3) gelangen, und andererseits Photolumineszenzlicht von dem Kleber (3) an das Auge des Betrachters gelangen. Hierfür geeignete Kunststoffsubstrate (2A0) bestehen bspw. aus glasfaserverstärktem Epoxyd, Polyester oder Polyamid. In einer Ausführungsform dieser Ausgestaltung ist auch das Vergußgehäuse (2B) für ultraviolette Strahlung und für die Photolumineszenzstrahlung des photolumineszierenden Klebers (3) zumindest teilweise transparent, wobei der photolumineszierende Kleber (3) zumindest teilweise auch auf dem Vergußgehäuse (2B) aufgebracht ist.

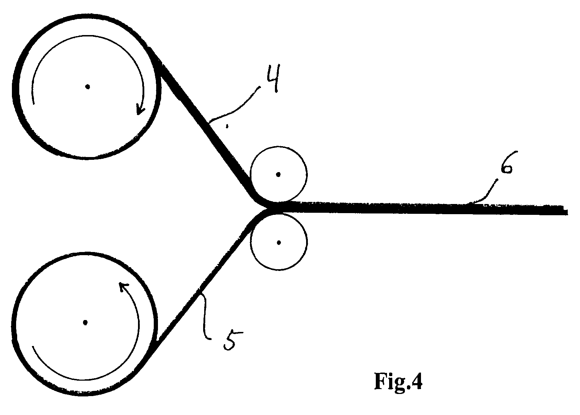

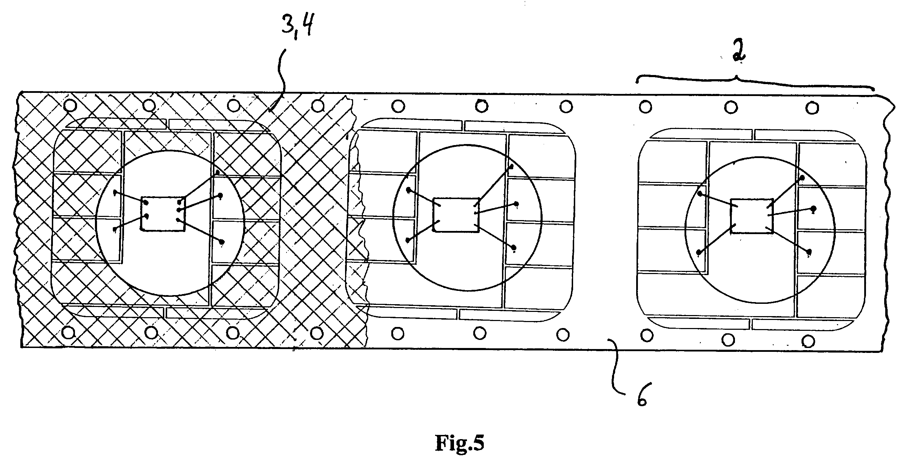

In Fig.4 ist ein Verfahren zur Herstellung eines Zwischenerzeugnisses (6) - siehe auch Fig.5 - für Chipkarten schematisch dargestellt. Dabei wird der photolumineszierende Kleber (3) als Klebeband (4) im Rolle/ Rolle-Verfahren auf ein zur Herstellung von Trägerelementen (2) dienendes Kunststoffsubstratband (5) aufgebracht, das für eine Vielzahl von Trägerelementen (5) Kontaktflächen (2A1) und Vergußgehäuse (2B) mit Chips (2B0) aufweist. Das aufzubringende photolumineszierende Klebeband (4) weist dabei Aussparungen für die Vergußgehäuse (2B) auf, so daß diese anschließend nicht oder nur im Randbereich mit der photolumineszierenden Klebeschicht (3) bedeckt sind. Damit es beim Wiederaufwickeln des erfindungsgemäß beschichteten Bandes (6) nicht zu Verklebungen kommt, wird vorzugsweise ein nicht klebendes, entfernbares Zwischenband (nicht dargestellt) eingelegt. Vor der Implantation werden dann aus dem erfindungsgemäß beschichteten Kunststoffsubstratband (6) die einzelnen Trägerelemente (2) durch Stanzen herausgelöst, die dann bereits mit einer photolumineszierenden Klebeschicht (3) versehen sind. Soll dieses Zwischenerzeugnis (6) für Chipkarten gemäß der ersten Ausgestaltung verwendet werden, so wird als Klebeband (4) ein Heißklebeband verwendet.

In einer Ausführungsform weist der Kleber (3) optische Aufheller, z.B. Derivate der Diaminostilbensulfosäure, Benzidin, Benzidazol, Oxazolderivate als photolumineszierende Bestandteile auf.

In einer weiteren Ausführungsform weist der Kleber (3) sogenannte Fluoreszenzfarben, z.B. Rhodamin oder Fluorescein, als photolumineszierende Bestandteile auf.

In beiden Fällen ist der Kleber (3) in seinem Volumen gleichmäßig mit den photolumineszierenden Bestandteilen durchsetzt. Dabei hat sich gezeigt, daß diese die Klebeeigenschaften nicht beeinträchtigen.

Im oberen Diagramm der Fig. 9 ist das Emissionsspektrum einer ultravioletten Strahlungsquelle dargestellt. Der Wellenlängenbereich für die Anregung der Photolumineszenz liegt typischerweise zwischen 200 nm und 300 nm. In den darunter liegenden Diagrammen sind für verschiedene Klebeschichten, die jeweils unterschiedliche photolumineszierende Bestandteile enthalten, die Photolumineszenzspektren gezeigt. Je nach Wahl der photolumineszierenden Bestandteile kann der gesamte sichtbare Spektralbereich von blau bis rot insgesamt oder selektiv abgedeckt werden. So könnten sich beispielsweise verschiedene Kartenhersteller jeweils durch Wahl eines bestimmten phtotolumineszierenden Klebers voneinander unterscheiden.

Ein besonderes Maß an Fälschungssicherheit wird erzielt, wenn ein optischer Sensor (8) zum Empfang und zur Auswertung der Photolumineszenzstrahlung vorgesehen ist. In diesem Fall sind das Photolumineszenz-Emissionsspektrum der Klebeschicht (3) und die ultraviolette Strahlungsquelle (7) auf die Empfangscharakteristik des optischen Sensors (8) abgestimmt, der die von der Klebeschicht (3) ausgehende Photolumineszenz-Strahlung empfängt, auswertet und mit einem vorgegebenen Erwartungswert vergleicht. Hierfür wird eine kalibrierte UV-Strahlungsquelle mit einem definierten Emissionsspektrum und definierter Intensität eingesetzt. Dabei wird in einer ersten Ausführungsform dieses Sicherheitssystems die spektrale Energieverteilung (das Farbspektrum) der Photolumineszenz-Strahlung ausgewertet. Alternativ oder auch zusätzlich wird die Intensität (Helligkeit) der Photolumineszenz-Strahlung ausgewertet. Die Intensität der Photolumineszenzstrahlung wird bestimmt durch die Konzentration der photolumineszierenden Bestandteile im Kleber, durch die Intensität und Einschaltzeit der UV-Lampe sowie ggf. durch die Absorption des Kunststoffsubstrats. Weiterhin ist es vorgesehen, das Nachleuchten der Photolumineszenzstrahlung nach dem Ausschalten der ultravioletten Strahlungsquelle (7) auszuwerten. Das Nachleuchten ist das charakteristische Phänomen der Phosphoreszenz. Aber auch bei der Fluoreszenz gibt es ein Nachleuchten, nur das hier das Nachleuchten sehr viel schneller abklingt als im Fall der Phosphoreszenz. Photolumineszierende Stoffe mit Nachleuchtzeiten im Bereich zwischen 10⁻⁴ sec. bis hin zu einigen zehn Sekunden bezeichnet man als phosphoreszierend. Stoffe mit Nachleuchtzeiten von 10⁻⁹ sec. bis 10⁻⁵ sec. bezeichnet man als fluoreszierend. Dabei sind aber auch die kurzen Nachleuchtzeiten elektronisch meßbar und lassen sich somit erfindungsgemäß auswerten.

Durch die Verwendung eines hinsichtlich der vorstehend aufgeführten Parameter ganz speziell abgestimmten photolumineszierenden Klebers wird ein erhöhtes Maß an Sicherheit erreicht, da nur eine Chipkarte mit diesem Kleber in dem System hinsichtlich der Photolumineszenz erwartungsgemäß reagiert.

Darüber hinaus ist es noch vorgesehen, mit Hilfe des optischen Sensors (8) die Konturen des Photolumineszenzlichtes hinsichtlich Licht und Schatten auszuwerten, die durch die verdeckenden Kontaktflächen sowie ggf. durch den Verlauf der umlaufenden Rille gegeben sind. Denn diese Größen sind ebenfalls spezifisch für bestimmte Trägerelemente/Chipkarten.

### Bezugszeichenliste:

1) Kartenkörper
   1A) Aussparung im Kartenkörper
   1B) Vertiefung in der Aussparung
   1C) Auflageschulter in der Aussüarung um die Vertiefung herum
   1D) umlaufende Rille zwischen dem in die Aussparung eingesetzten Trägerelement und dem Kartenkörper,
2) Trägerelement
   2A) erstes Teil
      2A0) Kunststoffsubstrat
      2A1) Kontaktflächen
      2A2) isolierende, lichte zwischenräume Zwischen den Kontaktflächen
   2B) zweites Teil
      2B0) Chip
      2B1) Anschlußleitungen
3) photolumineszierender Kleber
4) photolumineszierendes Klebeband
5) Kunststoffsubstratband mit einer Vielzahl von Trägerelementen
6) Zwischenerzeugnis: mit einem photolumineszierenden Klebeband beschichtetes Kunststoffsubstratband
7) UV-Strahlungsquelle,z.b. Schwarzlichtlampe
8) optischer Sensor

## Patentansprüche

1. Chipkarte mit einem Trägerelement (Chipmodul,2), das in eine Aussparung (1A) des Kartenkörpers (1) unter Freilassung einer umlaufenden Rille (1D) zwischen Trägerelement (2) und Kartenkörper (1) eingesetzt ist, wobei das Trägerelement (2) aus zwei Teilen (2A,2B) besteht,
nämlich einem ersten Teil (2A), das elektrisch leitfähige Kontaktflächen (2A1) aufweist, die auf einem Kunststoffsubstrat (20A0) angeordnet sind,
und einen zweiten Teil (2B) in Form eines Vergußgehäuses, das den Chip (2B0) und die Anschlußleitungen (2B1) des Chips (2B0) an die Kontaktflächen (2A0) aufnimmt, wobei der erste Teil (2A) über den Rand des zweiten Teils (2B) hinausragt und das Trägerelement (2) mit der den Kontaktflächen (2A0) gegenüberliegenden Seite auf dem Kunststoffsubstrat (2A0) zumindest in dem Bereich, wo das erste Teil (2A) das zweite Teil (2B) randseitig überragt, über einen Kleber (3) in der Aussparung (1A) des Kartenkörpers (1) fixiert ist,
dadurch gekennzeichnet, daß
der Kleber (3) photolumineszierend ist und zumindest teilweise in den Bereich der umlaufenden Rille (1D) hineinragt.

2. Verfahren zur Herstellung von Chipkarten nach Anspruch 1,
gekennzeichnet durch die folgenden Schritte,
1. die Bereitstellung eines Trägerelements (Chipmodul, 2), auf dessen Rückseite (den Kontaktflächen gegenüberliegend) eine photolumineszierende Heißklebeschicht (3) aufgebracht ist,
2. die Bereitstellung eines Kartenkörpers (1) mit Aussparung (1A),
3. das Einsetzten des Trägerelements (2) mittels eines beheizten Stempels unter dem Einfuß von Druck und Wärme in die Aussparung (1A) des Kartenkörpers (1), wobei die Zeitdauer für die Druck und Wärmebeaufschlagung, der Druck, die Temperatur sowie die Fläche und Dicke der aufgebrachten Heißklebeschicht (3) so gewählt sind, daß die Heißklebeschicht (3) teilweise in die um das Trägerelement (2) umlaufende Rille (1D) zwischen Kartenkörper (1) und Trägerelement (2) hineingepreßt wird.

3. Verfahren zur Herstellung von Chipkarten nach Anspruch 1, gekennzeichnet durch die folgenden Schritte,
1. die Bereitstellung eines Trägerelements (Chipmodul, 2),
2. die Bereitstellung eines Kartenkörpers (1) mit Aussparung (1A),
3. das Einbringen einer definierten Menge eines photolumineszierenden Klebers (3) in flüssiger oder pastöser Form in die Aussparung (1A) des Kartenkörpers (1),
4. das Einsetzen des Trägerelements (2) in die Aussparung (1A) des Kartenkörpers (1), wobei die Menge des photolumineszierenden Klebers (3) so dimensioniert ist, daß dieser beim Einsetzen zumindest teilweise in die um das Trägerelement (2) umlaufende Rille (1D) zwischen Kartenkörper (1) und Trägerelement (2) quillt.

4. Chipkarte mit einem Trägerelement (Chipmodul,2), das in eine Aussparung (1A) des Kartenkörpers (1) eingesetzt ist, wobei das Trägerelement (2) aus zwei Teilen (2A,2B) besteht,
nämlich einem ersten Teil (2A), das eine elektrisch leitfähige Kontaktflächen (2A1) bildende Metallisierung mit isolierenden, lichten Zwischenräumen (2A2) aufweist, die auf einem Kunststoffsubstrat (2A0) angeordnet ist,
und einen zweiten Teil (2B) in Form eines Vergußgehäuses, das den Chip (2B0) und die Anschlußleitungen (2B1) des Chips (2B0) an die Kontaktflächen (2A1) aufnimmt,
wobei der erste Teil (2A) über den Rand des zweiten Teils (2B) hinausragt und das Trägerelement (2) mit der den Kontaktflächen (2A1) gegenüberliegenden Seite auf dem Kunststoffsubstrat (2A1) zumindest in dem Bereich, wo das erste Teil (2A) das zweite Teil (2B) randseitig überragt, über einen Kleber (3) in der Aussparung (1A) des Kartenkörpers (1) fixiert ist,
dadurch gekennzeichnet, daß
der Kleber (3) photolumineszierend ist und das Kunststoffsubstrat (2A0) des Trägerelements (2) für ultraviolette Strahlung und für die Photolumineszenz-Strahlung des Klebers (3) zumindest teilweise transparent ist.

5. Chipkarte nach Anspruch 4,
dadurch gekennzeichnet, daß
auch das Vergußgehäuse (2B) für ultraviolette Strahlung und für die Photolumineszenz-Strahlung des Klebers (3) zumindest teilweise transparent ist.

6. Verfahren zur Herstellung eines Zwischenerzeugnisses für Chipkarten nach Anspruch 1,2,4 dadurch gekennzeichnet, daß
eine photolumineszierende Klebeschicht (3) als Klebeband (4) auf ein zur Herstellung von Trägerelementen (2) dienendes Kunststoffsubstratband (5), das für eine Vielzahl von Trägerelementen (2) Kontaktflächen (2A1) und Vergußgehäuse (2B) mit Chips (2b0) aufweist, im Rolle/Rolle-Verfahren aufgebracht wird.

7. Chipkarte nach Anspruch 1 oder 4,
dadurch gekennzeichnet, daß
der Kleber (3) optische Aufheller, z.B. Derivate der Diaminostilbensulfosäure, Benzidin, Benzidazol, Oxazolderivate als photolumineszierende Bestandteile aufweist.

8. Chipkarte nach Anspruch 1 oder 4,
dadurch gekennzeichnet, daß
der Kleber (3) Fluoreszenzfarben, z.B. Rhodamin oder Fluorescein als photolumineszierende Bestandteile aufweist.

9. System zur Prüfung der Echtheit von Chipkarten nach Anspruch 1 oder 4,
gekennzeichnet, durch
eine ultraviolette Strahlungsquelle (7) und einem optischen Sensor (8), der die von der Klebeschicht (3) ausgehende Photolumineszenz-Strahlung empfängt, auswertet und mit einem vorgegebenen Erwartungswert vergleicht.

10. System nach Anspruch 9,
dadurch gekennzeichnet, daß
die spektrale Energieverteilung (das Farbspektrum) der Photolumineszenz-Strahlung ausgewertet wird.

11. System nach Anspruch 9 oder 10,
dadurch gekennzeichnet, daß
die Intensität (Helligkeit) der Photolumineszenz-Strahlung ausgewertet wird.

12. System nach einem der Ansprüche 9 bis 11,
dadurch gekennzeichnet, daß
Nachleuchtzeiten der Photolumineszenz-Strahlung nach dem Ausschalten der ultravioletten Strahlungsquelle (7) ausgewertet werden.
